# EUROPÄISCHE PATENTSCHRIFT

(11) **EP 2 130 240 B1**
(45) Veröffentlichungstag und Bekanntmachung des Hinweises auf die Patenterteilung: **27.02.2013**
(21) Anmeldenummer: 08735693.7
(22) Anmeldetag: 02.04.2008
(51) Int. Cl.: H01L 41/338, B28D 5/04

(54) **VERFAHREN UND SYSTEM ZUM TRENNEN EINER VIELZAHL VON KERAMISCHEN BAUELEMENTEN AUS EINEM BAUELEMENTEBLOCK**
METHOD AND SYSTEM FOR DETACHING A PLURALITY OF CERAMIC COMPONENTS FROM A COMPONENT BLOCK
PROCÉDÉ ET SYSTÈME POUR SÉPARER UN BLOC DE COMPOSANTS EN PLUSIEURS COMPOSANTS CÉRAMIQUES

(30) Priorität: 04.04.2007 DE 102007016316
(43) Veröffentlichungstag der Anmeldung: 09.12.2009
(73) Patentinhaber: Siemens Aktiengesellschaft, 80333 München (DE)
(72) Erfinder: HAMANN, Christoph, 93107 Thalmassing (DE); SCHUH, Carsten, 85598 Baldham (DE)
(86) Internationale Anmeldenummer: PCT/EP2008/053941
(87) Internationale Veröffentlichungsnummer: WO 2008/122557

(56) Entgegenhaltungen:
- DE-A1- 19 959 414
- DE-A1-102004 013 038
- JP-A- 4 179 285
- US-A- 5 829 424

## Beschreibung

Die Erfindung betrifft ein Verfahren und ein System zum Trennen einer Vielzahl von keramischen Bauelementen aus einem Bauelementeblock.

Keramische Bauelemente sind beispielsweise Piezostapel oder Piezo-Stacks, die bei der Herstellung von Piezo-Aktoren verwendet werden.

Ein Piezoaktor besteht im Allgemeinen aus mehreren Piezo-Keramikplatten. Eine Piezo-Keramik ist ein Material, das sich aufgrund des piezo-elektrischen Effektes beim Anlegen einer elektrischen Spannung ausdehnt. Solche Piezo-Keramiken bilden die Basis für die Piezoaktoren, die beim Anlegen einer Spannung einen Verfahrweg von einigen Mikrometern realisieren.

Die Piezo-Keramiken werden beispielsweise als Grundkörper von Piezoaktoren eingesetzt, welche u.a. Verwendung im Kraftfahrzeugbereich, beispielsweise als elektromagnetische Wandler in Common-Rail-Einspritzanlagen für Brennkraftmaschinen, finden.

Die einzelnen oben beschriebenen Piezo-Keramiken sind beiderseits mit metallischen Elektroden bzw. Innenelektroden versehen. Wird an diese Innenelektroden eine Spannung angelegt, so reagiert die Piezo-Keramik mit einer Gitterverzerrung, die entlang der Hauptachse zu der oben bereits erläuterten nutzbaren Längenausdehnung führt. Da diese allerdings weniger als 2 Promille der Schichtdicke entlang der Hauptachse beträgt, muss zur Erzielung einer gewünschten absoluten Längenausdehnung eine entsprechend höhere Schichtdicke aktiver Piezo-Keramiken bereitgestellt werden. Mit zunehmender Schichtdicke der einzelnen Piezo-Keramik-Schichten innerhalb eines Piezoaktors steigt jedoch auch die zum Ansprechen des Piezoaktors erforderliche Spannung. Um diese in handhabbaren Grenzen zu halten, liegen die Dicken von einzelnen Piezoschichten bei Vielschicht-Aktoren üblicherweise zwischen 20 *µ*m und 200 *µ*m. Ein Piezoaktor muss daher beispielsweise für eine gewünschte Längenausdehnung eine entsprechende Anzahl an einzelnen Keramikschichten aufweisen.

Es ist der Anmelderin bekannt, zur Herstellung von Piezostapel oder Piezo-Stacks beispielsweise Piezo-Keramik-Grünfolien alternierend mit Innenelektrodenmaterial in einem Stapel anzuordnen.

Der Anmelderin ist weiter intern bekannt, die Piezostapel oder Piezo-Stacks im Mehrfachnutzen zu fertigen, indem eine Vielzahl von "grünen", ungesinterten Keramikfolien oder Piezo-Keramik-Grünfolien oder Piezoschichten aufeinander gestapelt und anschließend verpresst werden. Dieser Stapel ist anschließend in eine Vielzahl von einzelnen Bauelementen zu vereinzeln oder zu trennen. Das Trennen aus einem derartigen "Grünblock" ist aus JP 04179285 A bekannt.

Um diese Vereinzelung oder Trennung durchzuführen ist der Anmelderin intern eine Drahtsägetechnik bekannt. Mit Hilfe dieser Drahtsägetechnik können einzelne Piezostapel aus dem Grünblock oder Bauelementeblock herausgearbeitet werden. Dabei können insbesondere diamantbesetzte Sägedrähte eingesetzt werden. Dieser Sägedraht wird auf zwei Wickelspulen aufgezogen und im Verlauf des Trennschnittes entsprechend umspult. Dies bedeutet allerdings, dass eine große Drahtlänge, welche in Abhängigkeit der verwendeten Maschine bis über 10 m betragen kann, aktiv am Sägeprozess teilnimmt. Somit ist die verwendete Maschine entsprechend komplex aufgebaut und der Sägedraht wird in Folge der notwendigen Umlenk- und Spannrollen mechanisch hoch belastet, was die Lebensdauer des verwendeten Sägedrahtes reduziert und somit die Kosten entsprechend erhöht.

Aus den Veröffentlichungen DE 199 59 414 Al und DE 10 2004 013 038 Al ist jeweils ein Zerteilen eines Körpers aus sprödem Material bekannt. Dazu wird jeweils ein Drahtgitter verwendet. Ein derartiges Drahtgitter ist zum Zerteilen eines Körpers auch aus US-A-5 829 424 bekannt. Bei diesem bekannten Verfahren nach der US-A-5 829 424 wird zum Zerteilen eines Körpers der Draht von einer Abwickelspule über das nicht bewegte Drahtgitter geführt und anschließend wieder auf eine Aufwickelspule aufgewickelt. Auch ist es möglich, den Draht unsymmetrisch hin und her zubewegen.

Es ist eine Aufgabe der vorliegenden Erfindung, die keramischen Bauelemente auf einfache und insbesondere kostengünstige Weise zu vereinzeln.

Ferner ist es eine Aufgabe, ein Verfahren und ein System zum Vereinzeln oder Trennen der Vielzahl von keramischen Bauelementen aus einem keramischen Bauelementeblock bereitzustellen, welches eine erhöhte Lebensdauer für den verwendeten Sägedraht bereitstellt.

Außerdem ist es eine Aufgabe, ein Verfahren und ein System zum Trennen oder Vereinzeln einer Vielzahl von keramischen Bauelementen aus einem keramischen Bauelementeblock bereitzustellen, welches unabhängig von der Querschnittsform der herzustellenden Piezostapel ist.

Erfindungsgemäß wird zumindest eine dieser gestellten Aufgaben durch ein Verfahren mit den Merkmalen des Patentanspruchs 1 und/oder durch ein System mit den Merkmalen des Patentanspruchs 6 gelöst.

Demnach wird erfindungsgemäß ein Verfahren zum Trennen einer Vielzahl von keramischen Bauelementen aus einem keramischen Bauelementeblock vorgeschlagen, welches die folgenden Schritte umfasst:
- Bereitstellen des Bauelementeblockes oder Grünblockes;
- Einspannen einer Vielzahl paralleler Drahtsegmente oder Drahtabschnitte in einem Rahmen zur Ausbildung eines Sägegatters;
- Zersägen des bereitgestellten Bauelementeblockes in die Vielzahl der Bauelemente mittels des Sägegatters; und
- Bewegen des Sägegatters bei dem Zersägen des bereitgestellten Bauelementeblockes.

An dem Rahmen werden für jedes einzuspannende Drahtsegment zwei sich gegenüberliegende Drahtspanner angeordnet, mittels welchen das jeweilige Drahtsegment eingespannt wird, wobei bei Erreichen einer vorbestimmten Verschleißgrenze der in dem Rahmen eingespannten Drahtsegmente jeweils ein neues Drahtsegment mittels Nachführen eines Drahtes von einer Vorratsrolle in dem Rahmen eingespannt wird.

Des Weiteren wird ein System zum Trennen der Vielzahl von keramischen Bauelementen aus einem keramischen Bauelementeblock vorgeschlagen, das aufweist:
- ein Sägegatter, welches eine Vielzahl von parallelen, in einem Rahmen eingespannten Drahtsegmenten aufweist; und
- einen Aktor, welcher das Sägegatter zum Zersägen des Bauelementeblockes in die Vielzahl der Bauelemente antreibt oder bewegt;
- der Rahmen für jedes einzuspannende Drahtsegment zwei gegenüberliegende Drahtspanner aufweist, welche das jeweilige Drahtsegment einspannen; und
- eine Nachführvorrichtung vorgesehen ist zur Nachführung jeweils eines neuen Drahtsegments eines Drahtes von einer Vorratsrolle bei Erreichen einer vorbestimmten Verschleißgrenze der in dem Rahmen eingespannten Drahtsegmente.

Ein Vorteil der vorliegenden Erfindung besteht insbesondere darin, dass durch den Einsatz von mehreren Sägedrähten oder Drahtsegmenten oder Drahtabschnitten mit einem festen vordefinierten Abstand, welcher dem Rastermaß der einzelnen Piezostapel oder Piezo-Stacks im Grünblock oder Bauelementeblock entspricht, mehrere Piezostapel parallel bearbeitet werden können und der Trennvorgang des Nutzens oder Mehrfachnutzens entsprechend effektiv durchgeführt werden kann. Somit stellt die vorliegende Erfindung eine einfache und insbesondere auch kostengünstige Möglichkeit für das Vereinzeln der keramischen Bauelemente bereit.

Ferner können die Piezostapel in Folge der Verwendung des Sägegitters eine beliebige Querschnittsform aufweisen, z.B. rund, rechteckig, hexagonal, oval oder dergleichen. Dies wäre mittels eines herkömmlichen Trennverfahrens beispielsweise mit Hilfe von Sägeblättern oder der Drahtsägetechnik nicht darstellbar.

Außerdem ist erfindungsgemäß die mechanische und thermische Belastung der bereits getrennten Seitenflächen der Piezostapel durch die Reibung des Sägedrahtes sehr gering, die Oberflächen verschmieren nicht und es wird kein Druck auf den Sägedraht bzw. das Drahtsegment durch eine thermische Dehnung des Blockmaterials ausgeübt. Somit verlängert sich die Lebensdauer der verwendeten Drahtsegmente erheblich.

Vorteilhafte Ausgestaltungen und Weiterbildungen der Erfindung ergeben sich aus den Unteransprüchen sowie der Beschreibung unter Bezugnahme auf die Zeichnungen.

Gemäß einer bevorzugten Ausgestaltung der Erfindung wird eine vorbestimmte Drahtspannung des jeweiligen eingespannten Drahtsegmentes mittels der Drahtspanner eingestellt.

Gemäß einer weiteren bevorzugten Weiterbildung wird der Drahtspanner mittels einer Federvorrichtung federnd gelagert.

Gemäß einer weiteren bevorzugten Ausgestaltung wird der Bauelementeblock als ein Stapel ausgebildet, in welchem eine Vielzahl von Piezo-Keramik-Grünfolien oder Keramik-Grünfolien oder Piezoschichten alternierend mit einem Innenelektrodenmaterial angeordnet werden.

Gemäß einer weiteren bevorzugten Ausgestaltung wird das keramische Bauelement als ein Piezostapel ausgebildet, in welchem eine Vielzahl N von ersten Innenelektroden und eine Vielzahl N von zweiten Innenelektroden angeordnet wird, wobei eine Piezo-Keramik-Grünfolie zwischen einer ersten Innenelektrode und einer zweiten Innenelektrode angeordnet wird und die Vielzahl N erster Innenelektroden mit einer ersten Außenelektrode und die Vielzahl N zweiter Innenelektroden mit einer zweiten Außenelektrode kontaktierbar ist.

Gemäß einer weiteren bevorzugten Weiterbildung weist der Drahtspanner eine Einstellvorrichtung auf, welche eine vorbestimmte Drahtspannung des eingespannten Drahtsegmentes einstellt.

Gemäß einer weiteren bevorzugten Weiterbildung ist für zumindest einen Drahtspanner eine Federvorrichtung vorgesehen, welche den Drahtspanner federnd lagert. Vorzugsweise ist für jeden Drahtspanner eine eigene Federvorrichtung vorgesehen.

Ferner wird ein Piezo-Aktor mit einem Piezostapel vorgeschlagen, wobei der Piezostapel gemäß dem oben erläuterten Verfahren hergestellt ist.

Des Weiteren wird ein Einspritzsystem zum Einspritzen von Kraftstoff unter einem vorbestimmten Kraftstoffdruck vorgeschlagen, wobei das Einspritzsystem einen wie oben erläuterten Piezo-Aktor aufweist, welcher zum Heben und Senken einer Düsennadel geeignet ist, welche eine Düse öffnet und schließt, mittels der der Kraftstoff eingespritzt wird.

Die Erfindung wird nachfolgend anhand der in den schematischen Figuren angegebenen Ausführungsbeispiele näher erläutert. Es zeigen:
- Fig. 1: ein schematisches Blockschaltbild eines ersten Ausführungsbeispiels eines Systems zum Trennen der Vielzahl von keramischen Bauelementen aus einem keramischen Bauelementeblock;
- Fig. 2: ein schematisches Blockschaltbild eines zweiten Ausführungsbeispiels eines Systems zum Trennen der Vielzahl von keramischen Bauelementen aus einem keramischen Bauelementeblock;
- Fig. 3: ein schematisches Ablaufdiagramm eines Ausführungsbeispiels des erfindungsgemäßen Verfahrens zum Trennen der Vielzahl von keramischen Bauelementen aus einem keramischen Bauelementeblock; und
- Fig. 4: ein schematisches Blockschaltbild eines Piezostapels, welcher nach dem Verfahren gemäß Fig. 3 hergestellt ist.

In allen Figuren sind gleiche bzw. funktionsgleiche Elemente und Vorrichtungen - sofern nichts anderes angegeben ist - mit denselben Bezugszeichen versehen.

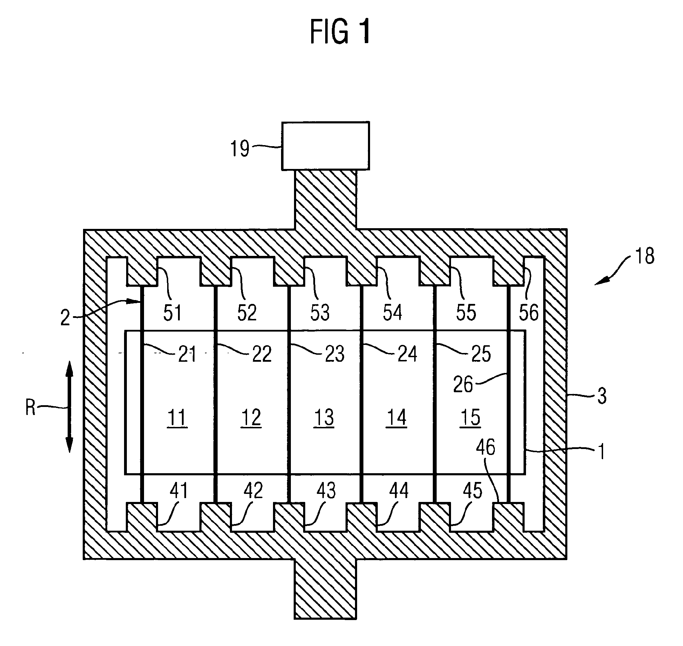

In Fig. 1 ist ein schematisches Blockschaltbild eines Systems 18 zum Trennen der Vielzahl von keramischen Bauelementen 11-15 aus einem keramischen Bauelementeblock 1 dargestellt. Das System 18 weist ein Sägegatter 2 und einen Aktor 19 auf. Das Sägegatter 2 weist eine Vielzahl von parallelen, in einem Rahmen 3 eingespannten Drahtsegmenten 21-26 auf. Der Aktor 19 treibt das Sägegatter 2 zum Zersägen des Bauelementeblockes 1 in die Vielzahl der Bauelemente 11-15 an bzw. bewegt dieses. Dabei zeigt das Bezugszeichen R in Fig. 1 die Sägerichtung. Ohne Einschränkung der Allgemeinheit sind in Fig. 1 sechs Drahtsegmente 21-26 dargestellt. Die Anzahl der in dem Rahmen 3 eingespannten Drahtsegmente 21-26 kann allerdings eine beliebige sein. Ferner ist in Fig. 1 ein Bauelementeblock 1 oder Grünblock mit einer quaderförmigen Form dargestellt. Auch diese Form des Grünblockes oder Bauelementeblockes ist nur beispielhaft, beliebig andere Formen sind denkbar.

Der Rahmen 3 weist für jedes einzuspannende Drahtsegment 21-26 zwei gegenüberliegende Drahtspanner 41-46; 51-56 auf, welche das jeweilige Drahtsegment 11-15 einspannen. Beispielsweise spannen die sich gegenüberliegenden Drahtspanner 41 und 51 das Drahtsegment 21 ein.

Vorzugsweise weist der Drahtspanner 41-46; 51-56 eine Einstellvorrichtung (nicht gezeigt) auf, welche eine vorbestimmte Drahtspannung des eingespannten Drahtsegmentes 21-26 einstellt.

Insbesondere ist für zumindest einen Drahtspanner 41-46; 51-56 eine Federvorrichtung (nicht gezeigt) vorgesehen. Insbesondere kann für jeden Drahtspanner 41-46; 51-56 eine eigene Federvorrichtung vorgesehen sein. Die Federvorrichtung lagert den jeweiligen Drahtspanner 41-46; 51-56 federnd.

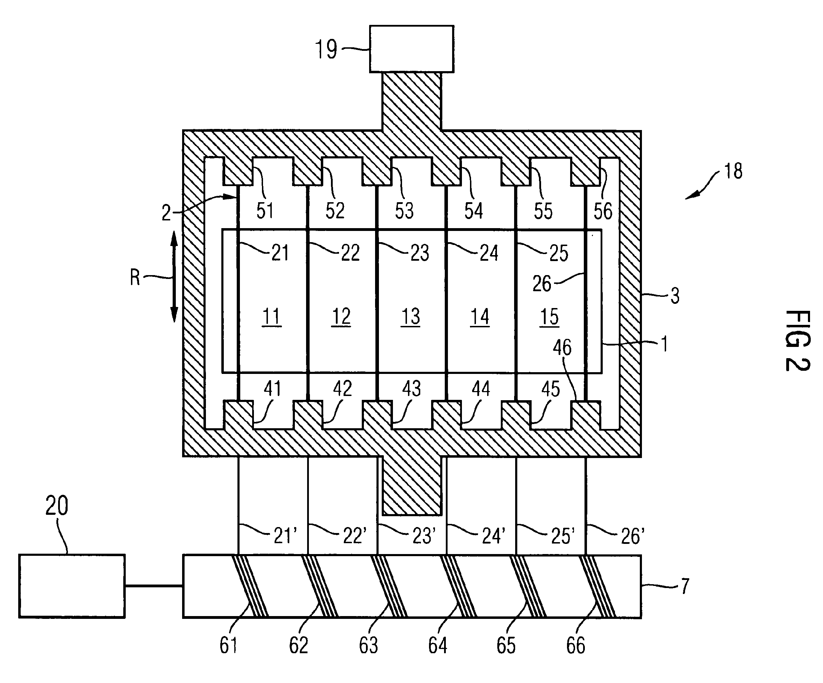

In Fig. 2 ist ein schematisches Blockschaltbild eines Ausführungsbeispiels eines Systems 18 zum Trennen der Vielzahl von keramischen Bauelementen 11-15 aus einem keramischen Bauelementeblock 1 dargestellt. Das zweite Ausführungsbeispiel gemäß Fig. 2 weist sämtliche Merkmale des ersten Ausführungsbeispiels gemäß Fig. 1 und eine Nachführvorrichtung 20 sowie eine Vorratsrolle 7 auf.

Die Nachführvorrichtung 20 ist dazu geeignet, bei Erreichen einer vorbestimmten Verschleißgrenze der in dem Rahmen 3 eingespannten Drahtsegmente 21-26 jeweils ein neues Drahtsegment 21'-26' eines Drahtes 61-66 von einer Vorratsrolle 7 nachzuführen, um die bisher eingespannten Drahtsegmente 21-26 durch die neuen Drahtsegmente 21'-26' zu ersetzen. Die Drahtsegmente 21-26 bzw. die neuen Drahtsegmente 21'-26' bzw. die Drähte 61-66 sind insbesondere als diamantbesetzte Sägedrähte ausgebildet.

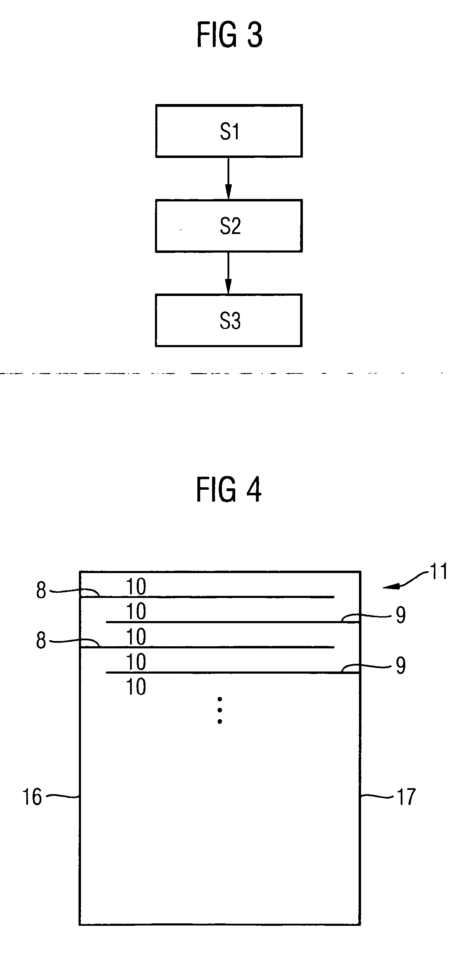

Fig. 3 zeigt ein schematisches Ablaufdiagramm eines Ausführungsbeispiels des erfindungsgemäßen Verfahrens zum Trennen einer Vielzahl von keramischen Bauelementen 11-15 aus einem keramischen Bauelementeblock 1. Nachfolgend wird das erfindungsgemäße Verfahren anhand des Ablaufdiagramms in Fig. 3 unter Verweis auf die Blockschaltbilder der Fig. 1 und 2 erläutert. Das erfindungsgemäße Verfahren weist folgende Verfahrensschritte S1-S3 auf:

### Verfahrensschritt S1:

Es wird ein Bauelementeblock 1 oder Grünblock bereitgestellt. Der Bauelementeblock 1 wird beispielsweise als ein Stapel ausgebildet, in welchem eine Vielzahl von Piezo-Keramik-Grünfolien alternierend mit einem Innenelektrodenmaterial angeordnet werden.

### Verfahrensschritt S2:

Eine Vielzahl paralleler Drahtsegmente 21-26 oder Drahtabschnitte wird einem Rahmen 3 zur Ausbildung eines Sägegatters 2 eingespannt. Dabei werden insbesondere zwei sich gegenüberliegende Drahtspanner 41-46; 51-56 für jedes einzuspannende Drahtsegment 21-26 an dem Rahmen 3 angeordnet. Mittels der jeweils gegenüberliegenden Drahtspanner 41-46; 51-56 wird das jeweilige Drahtsegment 21-26 eingespannt.

Vorzugsweise wird eine vorbestimmte Drahtspannung des eingespannten jeweiligen Drahtsegmentes 21-26 mittels des Drahtspanners 41-46; 51-56 eingestellt. Vorzugsweise wird der jeweilige Drahtspanner 41-46; 51-56 mittels einer Federvorrichtung federnd gelagert.

### Verfahrensschritt S3:

Der bereitgestellte Bauelementeblock 1 wird in die Vielzahl der Bauelemente 11-15 mittels des Sägegatters 2 zersägt. Vorzugsweise wird bei Erreichen einer vorbestimmten Verschleißgrenze der in dem Rahmen 3 eingespannten Drahtsegmente 21-26 jeweils ein neues Drahtsegment 21'-26' durch Nachführen eines Drahtes 61-66 von einer Vorratsrolle 7 in dem Rahmen 3 eingespannt. Alternativ kann auch das komplette Sägegatter 2 ausgetauscht werden oder in dieses neue Drahtsegment 21'-26' eingespannt werden.

Insbesondere ist das keramische Bauelement 11-15 als ein Piezostapel ausgebildet. Dazu zeigt Figur 4 ein schematisches Blockschaltbild eines solchen Piezostapels 11. Der Piezostapel 11 weist insbesondere eine Vielzahl N von ersten Innenelektroden 8 und eine Vielzahl N von zweiten Innenelektroden 9 auf. Weiter wird eine Piezo-Keramik-Grünfolie 10 oder Piezoschicht zwischen einer ersten Innenelektrode 8 und einer zweiten Innenelektrode 9 angeordnet. Ferner ist vorzugsweise die Vielzahl N erster Innenelektroden 8 mit einer ersten Außenelektrode 16 und die Vielzahl zweiter Innenelektroden 9 mit einer zweiten Außenelektrode 17 kontaktierbar.

Θbwohl die vorliegende Erfindung vorstehend anhand der bevorzugten Ausführungsbeispiele beschrieben wurde, ist sie darauf nicht beschränkt, sondern auf vielfältige Art und Weise modifizierbar. Beispielsweise ist es denkbar, die Erfindung nicht nur auf Piezostapel in monolithischer Vielschicht-Bauweise wie in den Ausführungsbeispielen der Figuren, sondern auf beliebige Piezo-Aktoren anzuwenden.

## Patentansprüche

1. Verfahren zum Trennen einer Vielzahl von keramischen Bauelementen (11-15) aus einem keramischen Bauelementeblock (1), mit den Schritten:
- Bereitstellen des Bauelementeblockes (1);
- Einspannen einer Vielzahl paralleler Drahtsegmente (21-26) in einem Rahmen (3) zur Ausbildung eines Sägegatters (2); und
- Zersägen des bereitgestellten Bauelementeblockes (1) in die Vielzahl der Bauelemente (11-15) mittels des Sägegatters (2),
**dadurch gekennzeichnet,**
**dass** bei dem Zersägen des bereitgestellten Bauelementeblockes (1) das Sägegatter (2) bewegt wird,
**dass** an dem Rahmen (3) für jedes einzuspannende Drahtsegment (21-26) zwei sich gegenüberliegende Drahtspanner (41-46; 51-56) angeordnet werden, mittels welchen das jeweilige Drahtsegment (21-26) eingespannt wird, und
**dass** bei Erreichen einer vorbestimmten Verschleißgrenze der in dem Rahmen (3) eingespannten Drahtsegmente (21-26) jeweils ein neues Drahtsegment (21'-26') mittels Nachführen eines Drahtes (61-66) von einer Vorratsrolle (7) in dem Rahmen (3) eingespannt wird.

2. Verfahren nach Anspruch 1
**dadurch gekennzeichnet,**
**dass** eine vorbestimmte Drahtspannung des eingespannten Drahtsegmentes (21-26) mittels der Drahtspanner (41-46; 51-56) eingestellt wird.

3. Verfahren nach Anspruch 1 oder 2
**dadurch gekennzeichnet,**
**dass** der Drahtspanner (41-46; 51-56) mittels einer Federvorrichtung federnd gelagert wird.

4. Verfahren nach Anspruch 1 oder einem der Ansprüche 2 bis 3,
**dadurch gekennzeichnet,**
**dass** der Bauelementeblock (1) als ein Stapel ausgebildet wird, in welchem eine Vielzahl von Piezo-Keramik-Grünfolien alternierend mit einem Innenelektrodenmaterial angeordnet wird.

5. Verfahren nach Anspruch 1 oder einem der Ansprüche 2 bis 4,
**dadurch gekennzeichnet,**
**dass** das keramische Bauelement (11-15) als ein Piezostapel ausgebildet wird, in welchem eine Vielzahl N von ersten Innenelektroden (8) und eine Vielzahl N von zweiten Innenelektroden (9) angeordnet wird, wobei eine Piezo-Keramik-Grünfolie (10) zwischen einer ersten Innenelektrode (8) und einer zweiten Innenelektrode (9) angeordnet wird und die Vielzahl N erster Innenelektroden (8) mit einer ersten Außenelektrode (16) und die Vielzahl N zweiter Innenelektroden (9) mit einer zweiten Außenelektrode (17) kontaktierbar ist.

6. System (18) zum Trennen der Vielzahl von keramischen Bauelementen (11-15) aus einem keramischen Bauelementeblock (1), mit:
- einem Sägegatter (2), welches eine Vielzahl von parallelen, in einem Rahmen (3) eingespannten Drahtsegmenten (21-26) aufweist; und
- einem Aktor (19), welcher das Sägegatter (2) zum Zersägen des Bauelementeblockes (1) in die Vielzahl der Bauelemente (11-15) antreibt,
**dadurch gekennzeichnet,**
**dass** der Rahmen (3) für jedes einzuspannende Drahtsegment (21-26) zwei gegenüberliegende Drahtspanner (41-46; 51-56) aufweist, welche das jeweilige Drahtsegment (21-26) einspannen, und
**dass** eine Nachführvorrichtung (20) vorgesehen ist zur Nachführung jeweils eines neuen Drahtsegments (21'-26') eines Drahtes (61-66) von einer Vorratsrolle (7) bei Erreichen einer vorbestimmten Verschleißgrenze der in dem Rahmen (3) eingespannten Drahtsegmente (21-26).

7. System nach Anspruch 6,
**dadurch gekennzeichnet,**
**dass** der Drahtspanner (41-46; 51-56) eine Einstellvorrichtung aufweist, welche eine vorbestimmte Drahtspannung des eingespannten Drahtsegmentes (21-26) einstellt.

8. System nach Anspruch 6 oder 7,
**dadurch gekennzeichnet,**
**dass** eine Federvorrichtung für zumindest einen Drahtspanner (41-46; 51-56) vorgesehen ist, welche den Drahtspanner (41-46; 51-56) federnd lagert.

9. Piezo-Aktor mit einem Piezostapel (11-15), welcher gemäß dem Verfahren nach Anspruch 6 hergestellt ist.

10. Einspritzsystem zum Einspritzen von Kraftstoff unter einem vorbestimmten Kraftstoffdruck mit einem Piezo-Aktor nach Anspruch 9 welcher zum Heben und Senken einer Düsennadel geeignet ist, welche eine Düse öffnet und schließt, mittels der der Kraftstoff eingespritzt wird.

## Claims

1. Method for separating a multiplicity of ceramic components (11-15) from a ceramic component block (1), having the steps:
- providing the component block (1);
- clamping a multiplicity of parallel wire segments (21-26) into position in a frame (3) for embodying a saw frame (2); and
- sawing the component block (1) that has been provided into the multiplicity of components (11-15) using the saw frame (2),
**characterised in that**
the saw frame (2) is moved when sawing up the component block (1) that has been provided,
two wire clamps (41-46; 51-56) are arranged mutually opposite on the frame (3) for each wire segment (21-26) requiring to be clamped into position, by means of which clamps the respective wire segment (21-26) is clamped into position and
whenever a pre-defined wear limit has been reached for the wire segments (21-26) clamped into position in the frame (3), a new wire segment (21'-26') will be clamped into position in the frame (3) by feeding out a wire (61-66) from a supply roll (7).

2. Method according to claim 1
**characterised in that**
a pre-defined wire tension is set by means of the wire clamps (41-46; 51-56) for the respective wire segment (21-26) clamped into position.

3. Method according to claim 1 or 2
**characterised in that**
the wire clamp (41-46; 51-56) is spring-mounted by means of a spring device.

4. Method according to claim 1 or one of claims 2 to 3
**characterised in that**
the component block (1) is embodied as a stack in which a multiplicity of piezoceramic green films are arranged alternating with an inner-electrode material.

5. Method according to claim 1 or one of claims 2 to 4
**characterised in that**
the ceramic component (11-15) is embodied as a piezo stack in which are arranged a multiplicity N of first inner electrodes (8) and a multiplicity N of second inner electrodes (9), with a piezoceramic green film (10) being arranged between a first inner electrode (8) and a second inner electrode (9) and the multiplicity N of first inner electrodes (8) being contactable with a first outer electrode (16) and the multiplicity N of second inner electrodes (9) being contactable with a second outer electrode (17).

6. A system (18) for separating the multiplicity of ceramic components (11-15) from a ceramic component block (1), having:
- a saw frame (2) having a multiplicity of parallel wire segments (21-26) clamped into position in a frame (3); and
- an actuator (19) that drives the saw frame (2) for sawing the component block (1) into the multiplicity of components (11-15),
**characterised in that**
for each wire segment (21-26) requiring to be clamped into position the frame (3) has two mutually opposite wire clamps (41-46; 51-56) that clamp the respective wire segment (21-26) and
a feed device (20) is provided which feeds out a new wire segment (21'-26') of a wire (61-66) from a supply roll (7) whenever a pre-defined wear limit has been reached for the wire segments (21-26) clamped into position in the frame (3).

7. System according to claim 6,
**characterised in that**
the wire clamps (41-46; 51-56) have a setting device which sets a predetermined wire tension between the wire segment (21-26) clamped into position.

8. System according to claim 6 or 7,
**characterised in that**
a spring device for at least one wire clamp (41-46; 51-56) is provided, which spring-mounts the wire clamp (41-46; 51-56).

9. Piezo-actuator having a piezo stack (11-15) that has been produced in keeping with the method according to claim 6.

10. Injection system for injecting fuel under a pre-defined fuel pressure having a piezo-actuator according to claim 9 which is suitable for raising and lowering an injector needle that opens and closes an injector by means of which the fuel is injected.

## Revendications

1. Procédé pour séparer un bloc de composants céramiques (1) en une pluralité de composants céramiques (11-15), comprenant les étapes :
- préparation du bloc de composants (1) ;
- fixation d'une pluralité de segments de fil parallèles (21-26) tendus dans un cadre (3) pour former un châssis de scie (2) ; et
- découpage à la scie du bloc de composants (1) préparé en la pluralité des composants (11-15) au moyen du châssis de scie (2),
**caractérisé en ce que**, lors du découpage à la scie du bloc de composants (1) préparé, le châssis de scie (2) est déplacé,
**en ce que** le cadre (3) est pourvu, pour chaque segment de fil (21-26) à fixer tendu, de deux tendeurs de fil (41-46; 51-56) opposés l'un à l'autre au moyen desquels le segment de fil respectif (21-26) est fixé tendu, et
**en ce que**, lorsqu'une limite d'usure prédéterminée des segments de fil (21-26) fixés tendus dans le cadre (3) est atteinte, un nouveau segment de fil (21'-26') correspondant est fixé tendu dans le cadre (3) grâce à une alimentation permanente d'un fil (61-66) d'un rouleau de réserve (7).

2. Procédé selon la revendication 1, **caractérisé en ce qu'**une tension de fil prédéterminée du segment de fil (21-26) fixé tendu est réglée au moyen des tendeurs de fil (41-46; 51-56).

3. Procédé selon la revendication 1 ou 2, **caractérisé en ce que** le tendeur de fil (41-46; 51-56) est monté de manière élastique au moyen d'un dispositif élastique.

4. Procédé selon la revendication 1 ou l'une des revendications 2 à 3, **caractérisé en ce que** le bloc de composants (1) est exécuté en tant qu'empilement dans lequel une pluralité de feuilles vertes piézocéramiques alternent avec un matériau d'électrode intérieure.

5. Procédé selon la revendication 1 ou l'une des revendications 2 à 4, **caractérisé en ce que** le composant céramique (11-15) est exécuté en tant qu'empilement piézoélectrique dans lequel une pluralité N de premières électrodes intérieures (8) et une pluralité N de secondes électrodes intérieures (9) sont disposées, une feuille verte piézocéramique (10) étant disposée entre une première électrode intérieure (8) et une seconde électrode intérieure (9) et un contact pouvant être établi entre la pluralité N de premières électrodes intérieures (8) et une première électrode extérieure (16) et entre la pluralité N de secondes électrodes intérieures (9) et une seconde électrode extérieure (17).

6. Système (18) pour séparer un bloc de composants céramiques (1) en la pluralité de composants céramiques (11-15), comprenant :
- un châssis de scie (2) qui comprend une pluralité de segments de fil (21-26) parallèles fixés tendus dans un cadre (3) ; et
- un actionneur (19) qui entraîne le châssis de scie (2) pour découper à la scie le bloc de composants (1) en la pluralité des composants (11-15),
**caractérisé en ce que** le cadre (3) est pourvu, pour chaque segment de fil (21-26) à fixer tendu, de deux tendeurs de fil (41-46; 51-56) opposés l'un à l'autre qui fixent le segment de fil respectif (21-26) en le tendant, et
**en ce que** l'on prévoit un dispositif d'alimentation permanente (20) pour l'alimentation permanente, à chaque fois, d'un nouveau segment de fil (21'-26') d'un fil (61-66) d'un rouleau de réserve (7) lorsqu'une limite d'usure prédéterminée des segments de fil (21-26) fixés tendus dans le cadre (3) est atteinte.

7. Système selon la revendication 6, **caractérisé en ce que** le tendeur de fil (41-46; 51-56) comprend un dispositif de réglage qui règle une tension de fil prédéterminée du segment de fil (21-26) fixé tendu.

8. Système selon la revendication 6 ou 7, **caractérisé en ce que** l'on prévoit un dispositif élastique pour au moins un tendeur de fil (41-46; 51-56), dispositif grâce auquel le tendeur de fil (41-46; 51-56) est monté de manière élastique.

9. Piézo-actionneur comprenant un empilement piézoélectrique (11-15) qui est fabriqué conformément au procédé selon la revendication 6.

10. Système d'injection pour injecter du carburant en appliquant une pression de carburant prédéterminée avec un piézo-actionneur selon la revendication 9 qui est adapté pour faire monter et descendre une aiguille d'injection qui ouvre et ferme un injecteur au moyen duquel le carburant est injecté.
